Europäisches Patentamt

European Patent Office

Office européen des brevets

(11) Veröffentlichungsnummer: **0 207 372**
**B1**

(12) **EUROPÄISCHE PATENTSCHRIFT**

(45) Veröffentlichungstag der Patentschrift: 05.09.90

(51) Int. Cl.⁵: **H 03 K 17/95**

(21) Anmeldenummer: 86108311.1

(22) Anmeldetag: 18.06.86

(54) Oszillator/Demodulator-Schaltungsanordnung für einen induktiven Annäherungsschalter.

(30) Priorität: 20.06.85 DE 3522120

(43) Veröffentlichungstag der Anmeldung:
07.01.87 Patentblatt 87/02

(45) Bekanntmachung des Hinweises auf die
Patenterteilung:
05.09.90 Patentblatt 90/36

(84) Benannte Vertragsstaaten:
AT CH DE FR GB IT LI NL SE

(56) Entgegenhaltungen:
EP-A-0 172 393
GB-A-2 075 201

ELECTRONIQUE & APPLICATIONS
INDUSTRIELLES, Nr. 233, 15. März 1977, Seite
63, Paris, FR: "Les détecteurs de proximité et de
passage à fente"

ELECTRONIQUE ET MICROELECTRONIQUE
INDUSTRIELLES, Nr. 207, 15. Juni 1975, Seiten
54-56, Paris, FR; J.M. ZULAUF: "Réalisez votre
détecteur de proximité à seuils réglables"

(73) Patentinhaber: Siemens Aktiengesellschaft
Wittelsbacherplatz 2
D-8000 München 2 (DE)

(72) Erfinder: Gehring, Gerhard, Dipl.-Ing.
Geschwister-Scholl-Strasse 7
D-8025 Unterhaching (DE)
Erfinder: Hödlmayr, Franz, Dipl.-Ing.
Werinherstrasse 101
D-8000 München 90 (DE)

**Beschreibung**

Die vorliegende Erfindung betrifft eine Oszillator/Demodulator-Schaltungsanordnung nach dem Oberbegriff des Patentanspruchs 1.

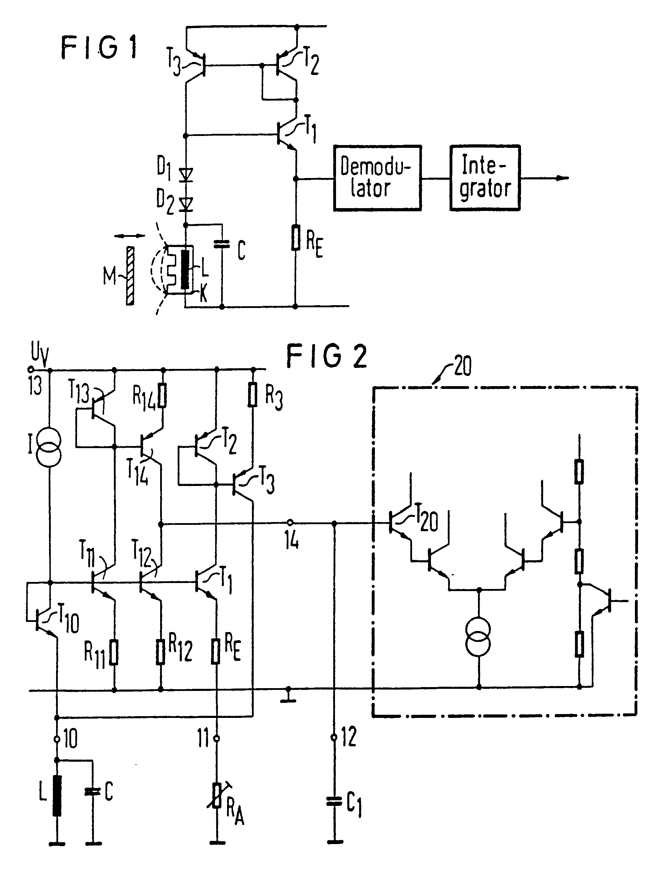

Eine Oszillator-Schaltungsanordnung mit nachgeschaltetem Demodulator und Integrator, wie sie beispielsweise aus·der Zeitschrift "Electronique et Microélectronique Industrielle", 15.06.1975, Seiten 54 bis 56 bekanntgeworden ist, ist im Prinzip in Fig. 1 dargestellt. Diese Schaltungsanordnung enthält eine durch einen Transistor $T_1$ mit einem Emitterwiderstand $R_E$ gebildete Transistorverstärkerstufe sowie eine Mitkopplung, die durch einen durch Transistoren $T_2$ und $T_3$ gebildeten Stromspiegel realisiert ist. Im Basiskreis des Transistors $T_1$ der Verstärkerstufe liegt ein durch einen Kondensator C und eine Spule L gebildeter Parallelresonanzkreis sowie in Serie zu diesem Resonanzkreis die Reihenschaltung zweier Dioden $D_1$ und $D_2$. Die Spule des Resonanzkreises besitzt einen offenen Halbschalen-Ferritkern K, wobei ein sich dadurch ausbildendes elektromagnetisches Feld schematisch durch gestrichelte Linien angedeutet ist. Wird dem Kern K ein Metallblech bzw. eine Metallfahne M angenähert, so wird ein Teil des genannten Feldes durch dieses Metallblech bzw. diese Metallfahne absorbiert und der Schwingkreis entsprechend bedämpft. Damit wird die Schwingungsamplitude kleiner oder die Schwingung reißt vollständig ab, wenn die Schleifenverstärkung kleiner als 1 wird.

In einer Schaltungsanordnung für einen Annäherungsschalter ist dem vorstehend erläuterten Oszillator ein Demodulator und ein Integrator nachgeschaltet, die in Fig. 1 lediglich schematisch dargestellt sind und auf die hier nicht näher eingegangen zu werden braucht.

Aus der CH—PS 421 237 sowie der ihr entsprechenden US—PS 3 350 660 ist bereits eine Schaltungsanordnung der in Rede stehenden Art bekanntgeworden, bei der dem Emitterwiderstand (entsprechend dem Widerstand $R_E$ in Fig. 1) ein Widerstand in Reihe geschaltet ist und dieser in Reihe geschaltete Widerstand zur Realisierung einer einstellbaren Abstandshysterese mittels eines elektronischen Schalters in Abhängigkeit vom Schwingungszustand des Oszillators (schwingender oder nichtschwingender Oszillator) in den Emitterkreis des Oszillatortransistors ein- bzw. abgeschaltet wird. Je nachdem, ob der Reihenwiderstand durch den elektronischen Schalter kurzgeschlossen oder in den Emitterkreis eingeschaltet ist, wird die Verstärkung im Oszillator erhöht oder erniedrigt, so daß die Umschaltung vom schwingenden in den nichtschwingenden Zustand des Oszillators (bzw. umgekehrt) bei an den frequenzbestimmenden Kreis des Oszillators angenähertem oder entferntem ferromagnetischen Objekt bei unterschiedlichen Abständen erfolgt, d.h., es ist eine Schalthysterese realisiert.

Aus der GB—A 2 075 201 ist es bekannt, bei einer Oszillator-Schaltungsanordnung dem Emitterwiderstand in Abhängigkeit vom Schaltzustand einen Hyteresewiderstand parallel zu schalten, um die Hysterese zu vergrößern.

Bei einer derartigen Realisierung einer Schalthysterese durch Änderung des Widerstandswertes im Emitterkreis des Oszillatortransistors sind Abstand absolut und relative Höhe der Hysterese nicht beliebig unabhängig voneinander einstellbar.

Der vorliegenden Erfindung liegt die Aufgabe zugrunde, eine Schaltungsanordnung der in Rede stehenden Art anzugeben, bei der eine derartige unabhängige Einstellung der beiden vorgenannten Größen möglich ist.

Diese Aufgabe wird bei einer Schaltungsanordnung der eingangs genannten Art erfindungsgemäß durch die Merkmale des Patentanspruchs 1 gelöst.

Ausgestaltungen des Erfindungsgedankens sind in Unteransprüchen gekennzeichnet.

Die Erfindung wird im folgenden anhand von in den Fig. 2 bis 8 der Zeichnungen dargestellten Ausführungsbeispielen näher erläutert. Es zeigt:

Fig. 2 ein Schaltbild einer Ausführungsform einer Oszillator/Demodulator-Schaltungsanordnung;

Fig. 3 bis 5 jeweils ein Teilschaltbild zur Erläuterung der Wirkungsweise der Schaltungsanordnung nach Fig. 2;

Fig. 6 und 7 jeweils ein ebenfalls der Erläuterung der Wirkungsweise der Schaltungsanordnung nach Fig. 2 dienendes Strom-Spannungsdiagramm; und

Fig. 8 ein Schaltbild einer Ausführungsform einer Oszillator/Demodulator-Schaltungsanordnung mit erfindungsgemäß realisierter Hysterese.

In der Schaltungsanordnung nach Fig. 2 entsprechen die Elemente $T_1$ bis $T_3$, $R_E$ sowie L, C den bereits erläuterten Elementen der bekannten Schaltungsanordnung nach Fig. 1. Da die erfindungsgemäße Schaltungsanordnung vorzugsweise in integrierter Schaltungstechnik ausgeführt wird, ist ein Eingangsanschluß 10 herausgeführt dargestellt, an den der Parallelresonanzkreis L, C außen anschließbar ist. Entsprechendes gilt für herausgeführte Anschlüsse 11, 12 und 13. Am Anschluß 11 ist ein Widerstand $R_A$ außen anschließbar, welcher in an sich bekannter Weise der Einstellung des Schaltabstands (Abstand des Metallblechs bzw. der Metallfahne M, bei dem der Annäherungsschalter schaltet) sowie der Schaltabstandshysterese für einen die erfindungsgemäße Oszillator/Demodulator-Schaltungsanordnung enthaltenden induktiven Annäherungsschalter dient. Dazu wird auf die eingangs genannte Druckschrift hingewiesen, in der die vorbekannte Schaltungsanordnung nach Fig. 1 beschrieben ist.

An den Anschluß 12 ist außen ein Integrationskondensator $C_1$ anschließbar, auf dessen Wirkungsweise hier auch nicht näher eingegangen wird, da seine Funktion an sich bekannt ist.

Am Anschluß 13 ist in die Schaltungsanordnung eine Versorgungsspannung $U_V$ einspeisbar.

2

Die Schaltungsanordnung gemäß Fig. 2 enthält weiterhin einen als Diode geschalteten, von einer Stromquelle I gespeisten Transistor $T_{10}$, der zum einen als Kompensationselement für die Schwellspannung der Basis-Emitterstrecke des die Verstärkerstufe des Oszillator/Demodulators bildenden Transistors $T_1$ wirkt. Insofern entspricht die Wirkungsweise diese als Diode geschalteten Transistors $T_{10}$ der Wirkungsweise einer der Dioden in der vorbekannten Schaltungsanordnung nach Fig. 1. Wie im folgenden jedoch noch genauer erläutert wird, geht die Funktion dieses als Diode geschalteten Transitors $T_{10}$ über die Funktion der entsprechenden Diode in der vorbekannten Schaltungsanordnung nach Fig. 1 hinaus, so daß sich deren Wirkungsweisen nicht mehr voll decken.

In der erfindungsgemäßen Schaltungsanordnung nach Fig. 2 bildet der als Diode geschaltete Transistor $T_{10}$ mit zwei weiteren Transistoren $T_{11}$ und $T_{12}$, in deren Emitterzweig jeweils ein Widerstand $R_{11}$ bzw. $R_{12}$ nach Masse liegt, einen ersten Stromspiegel, wobei der als Diode geschaltete Transistor $T_{10}$ als Bezugselement für diesen ersten Stromspiegel und die beiden Transistoren $T_{11}$ und $T_{12}$ mit dem jeweiligen Emitterwiderstand $R_{11}$, $R_{12}$ von diesem Bezugselement an ihren Basen gemeinsam angesteuert werden. Dabei sind der als Bezugselement dienende, als Diode geschaltete Transistor $T_{10}$ und die Basen der Transistoren $T_{11}$ und $T_{12}$ des ersten Stromspiegels sowie die Basis des die Verstärkerstufe bildenden Transistors $T_1$ miteinander verbunden; diese Verbindung wird im folgenden auch als "Basisschiene" bezeichnet.

Die erfindungsgemäße Schaltungsanordnung nach Fig. 2 enthält weiterhin einen zweiten Stromspiegel, der durch einen als Diode geschalteten Transistor $T_{13}$ sowie einen Transistor $T_{14}$ mit einem an der Versorgungsspannung liegenden Widerstand $R_{14}$ im Emitterzweig gebildet wird. In diesem zweiten Stromspiegel bildet der als Diode geschaltete Transistor $T_{13}$ ein Bezugselement, das den Transistor $T_{14}$ steuert. In den beiden Stromspiegeln sind die Kollektor-Emitterstrecken der Transistoren $T_{11}$ und $T_{13}$ bzw. $T_{12}$ und $T_{14}$ in Reihe geschaltet. Die Transistoren $T_{10}$, $T_{11}$, $T_{12}$ des ersten Stromspiegels besitzen gegenüber den Transistoren $T_{13}$, $T_{14}$ des zweiten Stromspiegels entgegengesetzten Leitungstyp. Weiterhin sind die Widerstände $R_{11}$, $R_{12}$ in den Emitterzweigen der gesteuerten Transistoren $T_{11}$, $T_{12}$ des ersten Stromspiegels größer als der Widerstand $R_{14}$ im Emitterzweig des gesteuerten Transistors $T_{14}$ im zweiten Stromspiegel.

Der Verbindungspunkt der Kollektoren der Transistoren $T_{12}$ und $T_{14}$ liegt an einem Ausgang 14 der erfindungsgemäßen Oszillator/Demodulator-Schaltungsanordnung.

Ersichtlich bilden die beiden vorstehend erläuterten Stromspiegel einen im Eingangskreis der Transistorverstärkerstufe $T_1$ wirksamen Doppelstromspiegel, wobei sich die von ihnen gelieferten Ströme, d.h. die Kollektorströme der Transistoren $T_{12}$ und $T_{14}$, am Schaltungsausgang 14 subtrahieren.

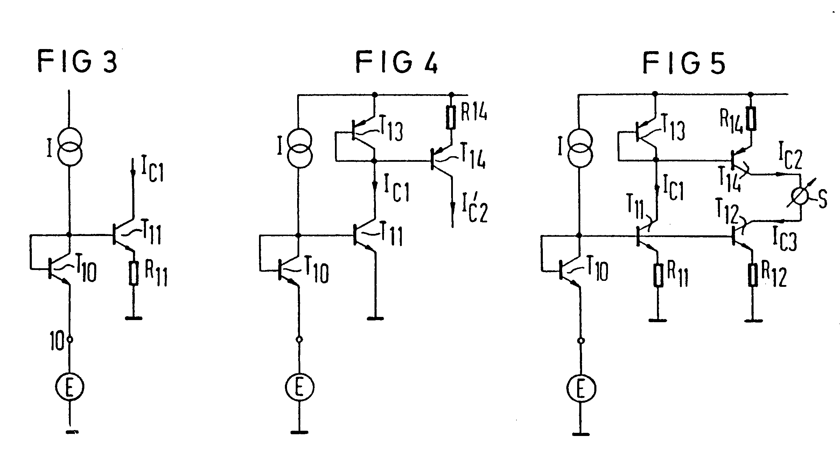

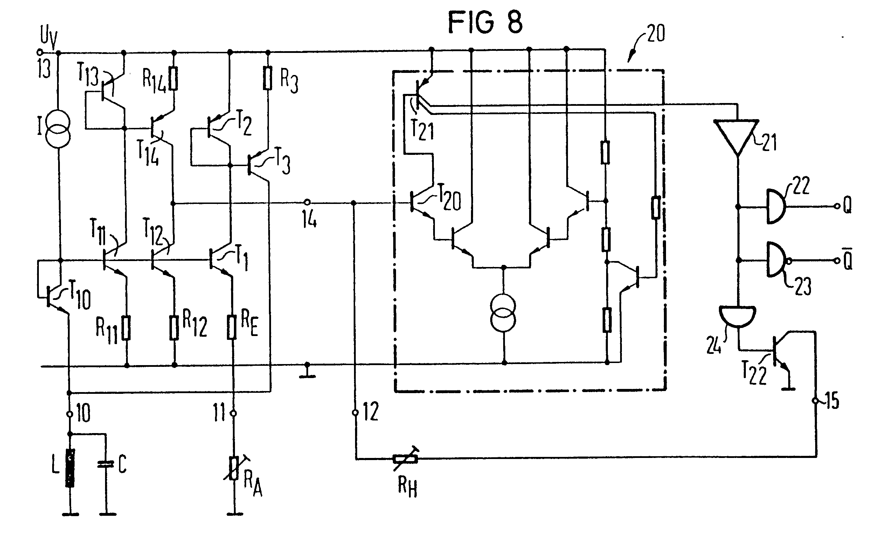

Um anzudeuten, daß die erfindungsgemäße Oszillator/Demodulator-Schaltungsanordnung einen Strom für nachfolgende Stufen in einem induktiven Annäherungsschalter liefern muß, ist in Fig. 2 weiterhin—hier zunächst schematisch—ein Schmitt-Trigger 20 dargestellt, in dem hier lediglich ein Eingangstransistor $T_{20}$ näher bezeichnet ist. Hierbei handelt es sich um eine an sich bekannte Stufe, die daher an dieser Stelle noch nicht näher erläutert wird. Für die hier zur Diskussion stehende Wirkungsweise—unabhängig von der Wirkungsweise der Schaltungsanordnung nach Fig. 8—ist lediglich wesentlich, daß die Oszillator/Demodulator-Schaltungsanordnung einen Ausgangsstrom zur Steuerung des Transistors $T_{20}$ im Schmitt-Trigger liefern muß, wie dies anhand der Fig. 3 bis 7 noch näher erläutert wird.

Um die Wirkungsweise der erfindungsgemäßen Schaltung erläutern zu können, wird gemäß Fig. 3 am Anschluß 10 anstelle des Resonanzkreises L, C gemäß Fig. 2 eine eine variable eingeprägte Spannung liefernde Quelle E angenommen. Zur weiteren Erklärung sei zunächst davon ausgegangen, daß der als Diode geschaltete Transistor $T_{10}$ immer von einem von der Stromquelle I gelieferten konstanten Strom von beispielsweise 10 µA durchflossen wird. Für Standardstrukturen mißt man dann an diesem als Diode geschalteten Transistor $T_{10}$ eine Flußspannung von 620 mV. Es wird weiter davon ausgegangen, daß der als Diode geschaltete Transistor $T_{10}$ sowie die Transistoren $T_{11}$, $T_{12}$ und $T_1$ gleiche Strukturen besitzen.

Ist die von der Quelle E gelieferte Spannung gleich Null, so führen die Transistoren $T_{11}$, $T_{12}$ und $T_1$ den gleichen Strom, solange die jeweiligen Emitterwiderstände $R_{11}$, $R_{12}$ und $R_E$ unwirksam sind.

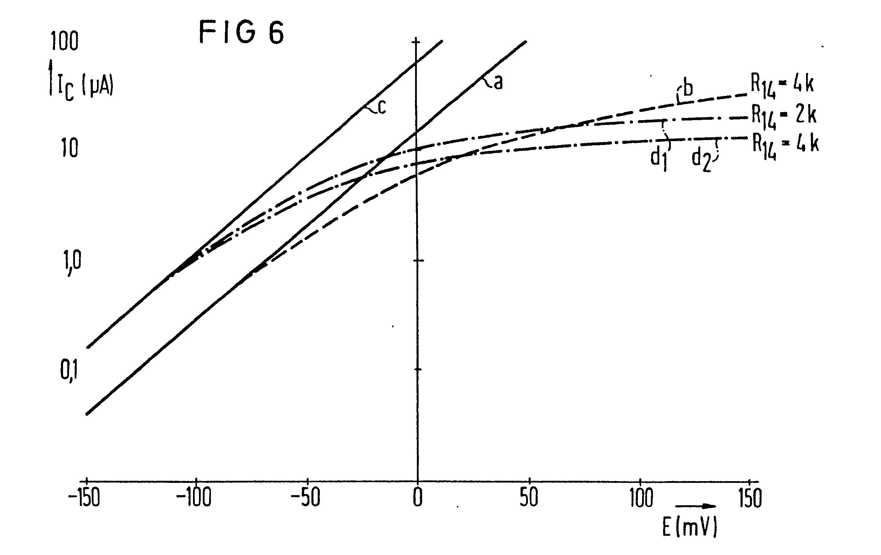

Varriiert man die von der Quelle E gelieferte Spannung beispielsweise von $-150$ mV bis $+150$ mV, wie dies im Diagramm nach Fig. 6 dargestellt ist, so ändern sich die Kollektorströme der genannten Transistoren gemäß der an sich bekannten Diodengleichung für die Basis-Emitterstrecke von Transistoren. Dieser Zusammenhang ist im Diagramm nach Fig. 6, in dem auf der Ordinate der Kollektorstrom $I_C$ logarithmisch aufgetragen ist, durch eine Gerade a aufgetragen.

Sind die Emitterwiderstände jedoch wirksam, so liegt der Verlauf der Kollektorströme gemäß einer Kurve b unterhalb der ursprünglichen Kurve a. Solange der Spannungsabfall an den Emitterwiderständen wesentlich kleiner als etwa 10 mV bleibt, ist die Abweichung von der Kurve a kaum merklich. Aufgrund des bereits genannten logarithmischen Diodengesetztes bedeutet eine Erhöhung der Basis-Emitter-Steuerspannung um 1 mV immer eine Erhöhung des Kollektorstrums um 4%. Je größer allerdings der Spannungsabfall an den Emitterwiderständen wird, um so stärker wird die Abweichung von der Kurve a.

Bei größeren Emitterflächen eines gesteuerten Transistors in einem Stromspiegel, beispielsweise um einen Faktor m, ist auch der Kollektorstrom um eben diesen Faktor m größer, solange ein Emitterwiderstand unwirksam ist. Dieser Fall ist durch eine Kurve c im Diagramm nach Fig. 6 dargestellt. Diese Kurve c verläuft exakt parallel zur Kurve a im Abstand m. Bei wirksamem Emitterwiderstand ergibt sich ebenso wie im Fall der Kurven a und b eine Abweichung von der Geraden, wie dies durch Kurven d1 und d2 dargestellt ist, wobei diese beiden Kurven für unterschiedliche Werte des Emitterwiderstands gelten. Bei einem Flächenverhältnis m von insbesondere 4 ist eine um etwa 36 mV kleinere Basis-Emitter-Steuerspannung für den gleichen Kollektorstrom verglichen mit der Bezugsstruktur erforderlich. Entsprechend der kleineren erforderlichen Basis-Emitter-Steuerspannung kann der Spannungsabfall am Emitterwiderstand für den gleichen Kollektorstrom größer sein. Infolgedessen biegen die Kurven d1 und d2 für unterschiedliche Werte des Emitterwiderstands härter von der Kurve c ab, als die Kurve b von der Kurve a.

Die in der Kurve a bzw. b dargestellten Verhältnisse entsprechen einem Stromspiegel nach Fig. 3 bzw. dem Stromspiegel $T_{10}$, $T_{11}$, $T_{12}$ und $T_1$ (im folgenden auch als "Strombank" bezeichnet).

Die durch die Kurven c bzw. d1, d2 dargestellten Verhältnisse entsprechen einem Stromspiegel nach Fig. 4 bzw. dem Stromspiegel $T_{13}$, $T_{14}$, $R_{14}$ angesteuert durch den Kollektorstrom des Transistors $T_{11}$, der in den Fig. 3 bis 5 mit $I_{c1}$ bezeichnet ist.

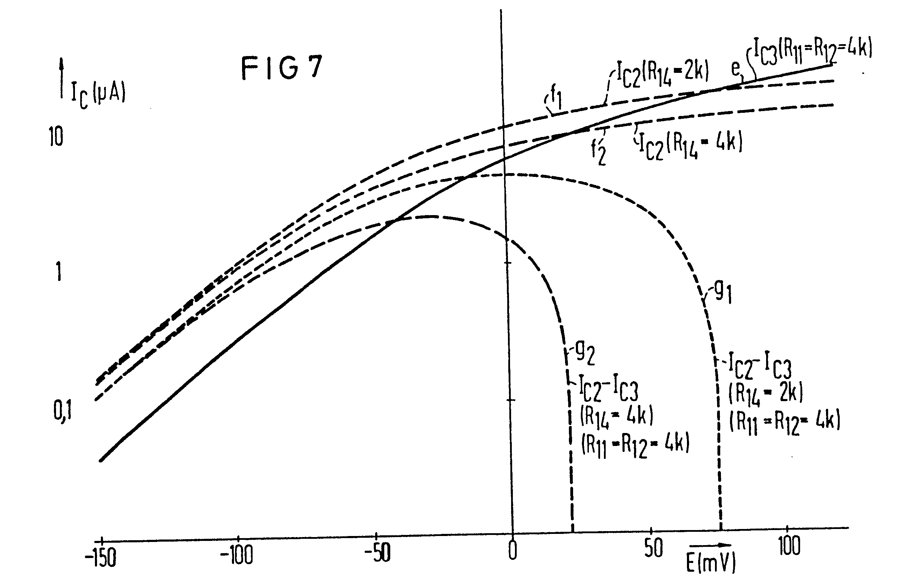

Der in den Ausgang 14 fließende Differenzstrom entspricht etwa der Differenz der Kurven b und d1, d2 nach Fig. 6 Dieser Sachverhalt ist in Fig. 5 derart dargegestellt, daß die Verbindung der Kollektoren der Transistoren $T_{14}$ und $T_{12}$ als aufgetrennt gedacht ist und die Differenz des jeweiligen mit $I_{c2}$ bzw. $I_{c3}$ bezeichneten Kollektorstroms durch ein Meßinstrument S gemessen wird. Die Differenz $I_{c2}-I_{c3}$ ist im Diagramm nach Fig. 7 für den jeweiligen Verlauf d1 bzw. d2 nach Fig. 6 in Form von Kurven g1 bzw. g2 dargestellt. Die Ströme $I_{c3}$ und $I_{c2}$ sind im Diagramm nach Fig. 7 durch Kurven e sowie f1 und f2 dargestellt, wobei die Kurven f1 und f2 entsprechend den Kurven d1 und d2 nach Fig. 6 wiederum für verschiedene Werte der Emitterwiderstände gelten. Auch im Diagramm nach Fig. 7 ist der Strom auf der Ordinate logarithmisch aufgetragen.

Wie das Diagramm nach Fig. 7 zeigt, ist der Differenzstrom $I_{c2}-I_{c3}$ gemäß den Kurven g1, g2 im gesamten Bereich in der Zeichenebene links von einem jeweiligen Schnittpunkt der Kurven f1, f2 und e positiv, d.h., der vom Kollektor des pnp-Transistors $T_{14}$ kommende Strom $I_{c2}$ ist größer als der Kollektorstrom $I_{c3}$ des npn-Transistors $T_{12}$. In diesem Bereich wird der Schmitt-Trigger 20 nach Fig. 2 aktiviert. Oberhalb bzw. rechts davon fällt der Differenzstrom steil ab und wechselt schließlich das Vorzeichen, so daß der Schmitt-Trigger 20 nach Fig. 2 deaktiviert wird.

Die Differenzstromkurve g1 bzw. g2 zeigt praktisch eine Gleichrichtercharakteristik. Steigt die vom der Quelle E gemäß den Fig. 3 bis 5 gelieferte Steuerspannung über den durch den jeweiligen vorgenannten Schnittpunkt an, so kommt der npn-Transistor $T_{12}$ in Sättigung. Es gilt dann nicht mehr der Zusammenhang, daß der Basisstrom gleich dem Quotienten aus Kollektorstrom und Stromverstärkung ist. Der Basisstrom steigt erheblich an, so daß die Strombank unwirksam wird.

Während die Impedanz an der durch die miteinander verbundenen Basen der Transistoren $T_{11}$, $T_{12}$ und $T_1$ gebildeten Basisschiene vorher sehr hoch war (etwa gleich dem Produkt der Werte der Emitterwiderstände und der Stromverstärkung), wird sie für Steuerspannungen, die größer als die den vorgenannten Schnittpunkten nach Fig. 7 entsprechenden Spannungen sind, um den Faktor der Stromverstärkung kleiner.

Der Rückkopplungsweg der Oszillator/Dämpfungs-Schaltungsanordnung nach Fig. 2 wird über den die Oszillatorverstärkerstufe bildenden Transistor $T_1$ und den Stromspiegel $T_2$, $T_3$, $R_3$ geschlossen. Am Eingangsanschluß 10 liegt anstelle der zum Zwecke der Erläuterung angenommenen Steuersignalquelle E nach den Fig. 3 bis 5 der Parallelresonanzkreis L, C eines Annäherungsschalters, wie dies eingangs bereits erläutert wurde. Ein Ansteigen der Spannung an diesem Resonanzkreis bewirkt einen steigenden Strom durch den Transistor $T_1$. Dieser Strom wird über den Stromspiegel $T_2$, $T_3$, $R_3$ gespiegelt und auf den Resonanzkreis rückgeführt ($R_3$ hat dabei nur eine gewisse stabilisierende Wirkung). Dieser Strom steigt ebenfalls an. An der Impedanz des Resonanzkreises führt dies wiederum zu einem Anstieg der Spannung, wobei diese Wirkung der Auslösung gleichgerichtet ist, d.h., es handelt sich um eine Mitkopplung, wie sie zur Auslösung jeder Schwingung erforderlich ist.

Die Schaltungsanordnung nach Fig. 2 enthält mehrere Stromquellen bzw. Stromsenken im erläuterten Sinne, die gemeinsam von der Steuerspannung am Einganganschluß 10 gesteuert werden. Dabei besitzen die Transistoren $T_{13}$, $T_{14}$ des zweiten Stromspiegels unterschiedliche Emitter-Flächenverhältnisse, wobei die Emitter-Flächenverhältnisse des als Bezugselement wirkenden Transistors $T_{13}$ und des gesteuerten Transistors $T_{14}$ insbesondere gleich 1:4 sind. Die Transistoren $T_{10}$, $T_{11}$ und $T_{12}$ im ersten Stromspiegel besitzen gleiche oder von 1 nicht sehr verschiedene Emitter-Flächenverhältnisse. Insbesondere sind auch die Widerstände $R_{11}$, $R_{12}$ in den Emitterzweigen der gesteuerten Transistoren $T_{11}$, $T_{12}$ im ersten Stromspiegel größer als der Widerstand $R_{14}$ im Emitterzweig des gesteuerten Transistors $T_{14}$ im zweiten Stromspiegel.

Durch die durch die Transistoren $T_{10}$ und $T_{11}$ (mit gleichen Flächenverhältnissen) gebildete Stromsenke (Fig. 3) fließt für eine Steuerspannung Null (bei unwirksamem Emitterwiderstand $R_{11}$) ein Strom, der gleich dem in die Diode $T_{10}$ eingeprägten Strom ist. Der Verlauf des Ausgangsstroms $I_{c1}$ (Fig. 3) als Funktion der Eingangs-Steuerspannung entspricht der Kurve b im Diagramm nach Fig. 6.

Dieser Strom $I_{c1}$ fließt gemäß Fig. 4 in die durch die pnp-Transistoren $T_{13}$, $T_{14}$ (mit unterschiedlichen Flächenverhältnissen) aufgebaute Stromquelle. Der von dieser Stromquelle gelieferte Strom $I'_{c2}$ ist um den Faktor m größer als der Strom $I_{c1}$, wenn m der Faktor ist, um den die Emitterfläche des Transistors $T_{14}$ größer als diejenige des Transistors $T_{13}$ ist. Dies gilt solange, als am entsprechenden Emitterwiderstand $R_{14}$ nur ein vernachlässigbar kleiner Spannungsabfall auftritt. Der Strom $I_{c2}$ dieser Stromquelle steigt aber für große Ströme aufgrund des dann größeren Spannungsabfalls im Verhältnis weniger stark an als der Strom $I_{c3}$ in dem eine Stromsenke bildenden Transistor $T_{12}$ gemäß Fig. 5. Dieser Sachverhalt ist im Diagramm nach Fig. 7 für unterschiedliche Werte des Widerstands $R_{14}$ in der jeweiligen Kurve f1 bzw. f2 dargestellt, welche den Kurven d1, d2 nach Fig. 6 entsprechen.

Die nachfolgende Schaltung in Form des Schmitt-Triggers 20 nach Fig. 2 wird vom Ausgangsanschluß 14, d.h. vom Verbindungspunkt der Kollektoren der Transistoren $T_{14}$ und $T_{12}$ angesteuert, d.h., die Differenz dieser beiden Kollektorströme $I_{c2}$ und $I_{c3}$ steht zur Ansteuerung des Eingangstransistors $T_{20}$ des Schmitt-Triggers 20 zur Verfügung. Wie bereits anhand der Diagramme nach den Fig. 6 und 7 erläutert wurde, ist der Kollektorstrom $I_{c2}$ der Stromquelle $T_{14}$ für kleine Ströme (also für negative Werte der Steuerspannung E) immer größer als der Strom $I_{c3}$ der Stromsenke $T_{12}$. Die Stromdifferenz $I_{c2}-I_{c3}$ ist also für negative Steuerspannungen E immer positiv. Der Kollektorstrom des die Stromquelle bildenden Transistors $T_{14}$ steigt jedoch bei größeren Strömen nur noch schwach an, so daß der Strom $I_{c3}$ ab einem bestimmten Wert der Steuerspannung überwiegt und sich—theoretisch—eine negative Stromdifferenz ergibt. Der Spannungsanstieg am Resonanzkreis L, C wird dann begrenzt, wenn die oben bereits erläuterte Sättigung des als Stromsenke wirkenden Transistors $T_{12}$ eintritt, wobei dann die Impedanz an der Basisschiene der Transistoren $T_{11}$, $T_{12}$, $T_1$ abfällt, wodurch der Resonanzkreis L, C drastisch (um mehr als den Faktor 100) stärker belastet wird und die Verstärkung sinkt. Nachdem die Amplitude am Schwingkreis bei dieser Begrenzung ihr Maximum erreicht hat, fällt sie in der gleichen Weise wie sie vorher angestiegen ist. Die im Schwingkreis gespeicherte Energie bewirkt, daß die Amplitude in negativer Richtung genau so groß wie in positiver Richtung wird (eine Gleichstromkomponente, d.h. eine Unsymmetrie ist am Schwingkreis nicht möglich).

Die Höhe der Begrenzung ist durch die Steuerspannung gegeben, bei der die Differenz der eingeprägten Ströme $I_{c2}-I_{c3}$ das Vorzeichen ändert. Sie wird durch die Dimensionierung der Emitterwiderstände $R_{11}$, $R_{12}$, $R_{14}$ sowie die Wahl der Emitter-Flächenverhältnisse im oben beschriebenen Sinne bestimmt.

Aus den vorstehenden Ausführungen ist ersichtlich, daß der erfindungsgemäße Doppelstromspiegel aufgrund der begrenzenden Wirkung gemäß den Kurven g1, g2 nach Fig. 7 gleichzeitig als Demodulator wirkt.

Für die vorstehenden Erläuterungen ist darauf hinzuweisen, daß der Begriff "Stromspiegel" im herkömmlichen Sinn eine exakte Proportionalität der Ströme in allen Zweigen impliziert. Die ist bei den betriebenen Stromspiegeln für kleine Ströme ebenfalls erfüllt (Kurven a und c in Fig. 6). Durch die beabsichtigte Unsymmetrie in den Emitterkreisen werden bewußt Transfer-Funktionen erreicht, die nicht mehr linearen Verlauf zeigen (Kurven b und d in Fig. 6). Im Sinne der Erfindung umfaßt der Begriff "Stromspiegel" diesen Sachverhalt mit.

Mit der erfindungsgemäßen Ausbildung des Doppelstromspiegels in einer Oszillator/Demodulator-Schaltungsanordnung wird eine Reihe von Vorteilen erreicht. Die Begrenzung (siehe Fig. 7) ist temperaturstabil und liegt bei Werten unterhalb von ca. 200 mV Spitze-Spitze. Weiterhin ist die Schleifenverstärkung größer und weniger steuernd.

Die Impedanzen am Abgleichanschluß 11 (Außenwiderstand $R_A$ nach Fig. 2) können niedriger gewählt werden und steuern weniger als in der Schaltungsanordnung Fig. 1. Schließlich ist auch die gleichzeitig erreichte Dmodulationsfunktion temperaturstabil, da keine weiteren Dioden-Temperaturkoeffizienten zu berücksichtigen sind. Die Demodulationskennlinie verläuft steil, was einer hohen Verstärkung entspricht.

Fig. 8 zeigt die Schaltungsanordnung nach Fig. 2 mit einer Ausführungsform einer erfindungsgemäß relaisierten Schalthysterese. Insoweit, als in Fig. 8 gleiche Elemente wie in der Schaltungsanordnung nach Fig. 2 mit gleichen Bezugszeichen versehen sind, wird auf die Erläuterungen zur Schaltungsanordnung nach Fig. 2 Bezug genommen.

Im Schmitt-Trigger 20 liegt an der Kollektor-Emitter-Strecke des Transistors $T_{20}$ mit seiner Basis ein Transistor $T_{21}$, dessen Emitter an der Versorgungsspannung $U_V$ (Anschluß 13) liegt. Dieser Transistor $T_{21}$ besitzt zwei Kollektoren, von denen einer über einen nicht näher bezeichneten Widerstand an die Basis eines ebenfalls nicht näher bezeichneten Transistors im Schmitt-Trigger 20 angekoppelt ist. Ein weiterer Kollektor des Transistors $T_{21}$ ist über einen Verstärker 21 auf die Eingänge zweier als Puffer wirkender Gatter 22 und 23 geführt. Über diese beiden Gatter 22 und 23 wird an zwei Ausgängen Q und $\bar{Q}$ ein antivalentes Logik-Ausgangssignal erzeugt.

Weiterhin ist der Ausgang des Verstärkers 21 auf ein weiteres als Puffer wirkendes Gatter 24 geführt, von dessen Ausgang ein elektronischer Schalter gesteuert wird. Im vorliegenden Ausführungsbeispiel handelt es sich dabei um einen Transistor-Schalter $T_{22}$. Der Kollektor dieses Schalttransistors $T_{22}$ ist über einen nach außen geführten Anschluß 15 der Schaltungsanordnung sowie einen veränderbaren Widerstand $R_H$ an den Anschluß 12 der Schaltungsanordnung geführt. Erfindungsgemäß ist es nicht erforderlich, daß es sich bei dem Element zwischen den Anschlüssen 12 und 15 um einen Einzelwiderstand handelt. Es kann vielmehr auch ein Widerstandsnetzwerk vorgesehen sein, das zur Änderung seines Gesamtwiderstandswertes umschaltbar ist, wozu ein elektronischer Schalter, wie etwa der Transistor $T_{22}$ dienen kann.

Die Wirkungsweise der Oszillator/Demodulator-Schaltungsanordnung nach Fig. 2 wurde oben im einzelnen anhand der Ersatzschaltbilder nach den Fig. 3 bis 5 sowie anhand der Diagramme nach den Fig. 6 und 7 erläutert. In der Schaltungsanordnung nach Fig. 8 liegen am Verstärker 21 nur noch digitale Signale, die über die Annäherung der Metallfahne M nach Fig. 1 und damit über den Zustand schwingender oder nichtschwingender Oszillator Auskunft geben.

Wesentlich für die Schaltungsanordnung ist, daß im Schaltungsteil vor dem Schmitt-Trigger 20 Oszillator und Demodulator in nicht trennbarer Weise funktionsmäßig miteinander verkoppelt sind, so daß die Beziehungen Abstand/Schwingamplitude, Schwingamplitude/Demodulatorstrom, Demodulatorstrom/Schaltpunkt so eindeutig auf Schaltungs- und Geometriebeziehungen fixiert sind, daß durch Umschaltung der Demodulatorbeschaltung eine eindeutige Zuordnung der Hysterese zum Abstand, also eine Abstandshysterese ohne beobachtbaren Einfluß von Toleranzen bzw. Schwankungen der Absolutwerte der Bauteile oder der Stromverstärkung von Transistoren realisiert ist. Die Eigenschaften der Demodulatorschaltung sind im Ausführungsbeispiel nach Fig. 8 im wesentlichen durch den einstellbaren Widerstand $R_H$ bestimmt, der in Abhängigkeit vom Ausgangssignal des Schmitt-Triggers 20 bei leitendem bzw. gesperrtem Schalttransistor $T_{22}$ entweder vom Schaltungsausgang 14 nach Masse gekoppelt oder unwirksam ist. Damit sind die Hysterese und der Abstand unabhängig voneinander über die Widerstände $R_A$ und $R_H$ einstellbar. Einer der wesentlichen Vorteile der vorstehend erläuterten Realisierung ist darin zu sehen, daß der für die Hysterese verantwortliche Wideestand $R_H$ nicht im Emitterkreis der Transistorverstärkerstufe $T_1$ liegt, so daß an ihm keine Schwingamplituden auftreten und damit mit diesem einhergehende parasitäre Kapazitäten das Schwingverhalten des Oszillators nicht mehr beeinflussen können.

## Patentansprüche

1. Schaltungsanordnung für einen Annäherungsschalter mit einer von Außen beeinflußbaren Oszillator/Demodulator-Schaltungsanordnung mit einer Transistorverstärkerstufe ($T_1$, $R_E$; $T_1$, $R_E$, $R_A$), in deren Eingangskreis ein bedämpfbarer Resonanzkreis (L, C) liegt, mit einer Mitkopplung ($T_2$, $T_3$, $R_3$) vom Ausgangskreis auf den Eingangskreis der Transistorverstärkerstufe ($T_1$, $R_E$; $T_1$, $R_E$, $R_A$), und mit einem Begrenzerzweig ($T_{10}$, $T_{12}$) im Eingangskreis der Transistorverstärkerstufe ($T_1$, $R_R$), mit einem im Eingangskreis der Transistorverstärkerstufe ($T_1$, $R_e$) wirksamen Doppelstromspiegel ($T_{10}$, $T_{11}$, $T_{12}$, $R_{11}$, $R_{12}$; $T_{13}$, $T_{14}$, $R_{14}$), in dem ein erster Stromspiegel ($T_{10}$, $T_{11}$, $T_{12}$, $R_{11}$, $R_{12}$) und ein zweiter Stromspiegel ($T_{13}$, $T_{14}$, $R_{14}$) derart miteinander gekoppelt sind, daß sich die von ihnen gelieferten Ströme ($I_{c2}$, $I_{c3}$) an einem Schaltungsausgang (14) subtrahieren, wobei die gemeinsame Bezugsgröße dieser gekoppelten Stromspiegel von einem den bedämpften Resonanzkreis (L, C) mit dem Steuereingang der Transistorverstärkerstufe ($T_1$, $R_E$; $T_1$, $R_E$, $R_A$) verbindenden Bezugselement abhängt, wobei die beiden mit ihren Stromausgängen den Schaltungsausgang (14) bildenden Stromspiegel bezüglich ihrer gemeinsamen Steuergröße unterschiedliche Transfer-Verhalten aufweisen und wobei die im Schaltungsausgang (14) subtrahierten Ströme von der Spannung am bedämpfbaren Resonanzkreis (L, C) abhängen, mit einem dem Schaltungsausgang (14) nachgeschalteten Integrator ($C_1$) und Schmitt-Trigger (20), wobei der Schaltabstand des Annäherungsschalters über mindestens einen im Emitterkreis des Oszillators wirksamen Widerstand ($R_A$) einstellbar ist und eine Schalthystherese aufweist, derart, daß zwischen der Hysterese und dem Schaltabstand des Annäherungsschalters eine feste Beziehung besteht, wobei zur schaltabstandsunabhängigen Justierung der Hysterese ein Widerstandsnetzwerk ($R_H$) in Abhängigkeit vom digitalen Ausgangssignal des Schmitt-Triggers (20) parallel zum Schaltungsausgang (14) geschaltet wird und wobei die relative Höhe der Hyterese durch Variation des Widerstandsnetzwerkes ($R_H$) einstellbar ist.

2. Schaltungsanordnung nach Anspruch 1, mit einer Logik (21 bis 24) zur Überführung eines Schmitt-Trigger-Ausgangssignales in ein antivalentes Logik-Ausgangssignal, dadurch gekennzeichnet, daß das Widerstandsnetzwerk ($R_H$) in Abhängigkeit von der Logik (21 bis 24) umschaltbar ist.

## Revendications

1. Montage pour un interrupteur de proximité comportant un montage oscillateur/démodulateur pouvant être influencé de l'extérieur et comprenant un étage amplificateur à transistor ($T_1$, $R_E$; $T_1$, $R_E$, $R_A$), dans le circuit d'entrée duquel est situé un circuit résonant pouvant être amorti (L, C), et comportant un circuit de réaction ($T_2$, $T_3$, $R_3$) partant du circuit de sortie pour aboutir au circuit d'entrée de l'étage amplificateur à transistor ($T_1$, $R_E$; $T_1$, $R_E$, $R_A$), et une branche formant limiteur ($T_{10}$, $T_{12}$) branchée dans le circuit d'entrée du circuit amplificateur à transistor ($T_1$, $R_E$), un miroir de courant double ($T_{10}$, $T_{11}$, $T_{12}$, $R_{11}$, $R_{12}$; $T_{13}$, $T_{14}$, $R_{14}$) agissant dans le circuit d'entrée de l'étage amplificateur à transistor ($T_1$, $R_e$) et dans lequel un premier miroir de courant ($T_{10}$, $T_{11}$, $T_{12}$, $R_{11}$, $R_{12}$) et un second miroir de courant ($T_{13}$, $T_{14}$, $R_{14}$) sont accouplés entre eux de telle sorte que les courants ($I_{c2}$, $I_{c3}$), qu'ils délivrent, se soustraient au niveau d'une sortie (14) du circuit, et dans lequel la grandeur de référence commune de ces miroirs de courant accouplés dépend d'un élément de référence qui relie le circuit résonnant amorti (L, C) à l'entrée de commande de l'étage amplificateur à transistor ($T_1$, $R_E$, $T_1$, $R_E$, $R_A$), et dans lequel les deux miroirs de courant formant, par leurs sorties de courant, la sortie (14) du circuit, possédent, par rapport à leur grandeur de commande commune, des comportements de transfert différents, et dans lequel les courants, soustraits l'un de l'autre au niveau de la sortie (14) du circuit, dépendent de la tension dans le circuit résonnant pouvant être amorti (L, C), et dans lequel il est prévu un intégrateur ($C_1$) et une bascule de Schmitt (20), branchés en aval de la sortie (14) du circuit, la distance de commutation de l'interrupteur de proximité étant réglable sur au moins une résistance ($R_A$) active dans le circuit d'émetteur de l'oscillateur, et possède une hystérésis de commutation de sorte qu'il existe une relation fixe entre l'hystérésis et la distance de commutation de l'interrupteur de proximité, et dans lequel pour l'ajustement de l'hystérésis indépendamment de la distance de commutation, un réseau de résistances ($R_H$) est branché en parallèle avec la sortie (14) du circuit, en fonction du signal de sortie numérique du déclencheur de Schmitt (20), et l'amplitude relative de l'hystérésis est réglable au moyen d'une variation du réseau de résistances ($R_H$).

2. Montage suivant la revendication 1, comportant une logique (21 à 24) pour convertir un signal de sortie du déclencheur de Schmitt en un signal de sortie logique antivalent, caractérisé par le fait que le réseau de résistances ($R_H$) est commutable en fonction de la logique (21 à 24).

## Claims

1. Circuit arrangement for a proximity switch with an externally influenceable oscillator/ demodulator circuit arrangement having a transistor amplifier stage ($T_1$, $R_E$; $T_1$, $R_E$, $R_A$), in the input circuit of which a dampable resonant circuit (L, C) is located, having a positive feedback ($T_2$, $T_3$, $R_3$) from the output circuit to the input circuit of the transistor amplifier stage ($T_1$, $R_E$; $T_1$, $R_E$, $R_A$), and having a limiter branch ($T_{10}$, $T_{12}$) in the input circuit of the transistor amplifier stage ($T_1$, $R_E$), having a dual current mirror ($T_{10}$, $T_{11}$, $T_{12}$, $R_{11}$, $R_{12}$; $T_{13}$, $T_{14}$, $R_{14}$) active in the input circuit of the transistor amplifier stage ($T_1$, $R_E$), in which dual current mirror a first current mirror ($T_{10}$, $T_{11}$, $T_{12}$, $R_{11}$, $R_{12}$) and a second current mirror ($T_{13}$, $T_{14}$, $R_{14}$) are coupled to one another in such a way that the currents ($I_{c2}$, $I_{c3}$) supplied by them are subtracted from one another at a circuit output (14), the common reference variable of these coupled current mirrors depending on a reference element connecting the damped resonant circuit (L, C) to the control input of the transistor amplifier stage ($T_1$, $R_E$; $T_1$, $R_E$, $R_A$), the two current mirrors forming the circuit output (14) with their current outputs having different transfer behaviours in respect of their common control variable and the currents subtracted in the circuit output (14) depending on the voltage at the dampable resonant circuit (L, C) having an integrator ($C_1$) connected downstream of the circuit output (14) and a Schmitt trigger (20), the switching interval of the proximity switch being settable via at least one resistor ($R_A$) active in the emitter circuit of the oscillator and having a switching hysteresis such that there is a fixed relation between the hysteresis and the switching interval of the proximity switch, for the purpose of adjusting the hysteresis independently of the switching interval, a resistance network ($R_E$) being swtiched as a function of the digital output signal of the Schmitt trigger (20) in parallel to the circuit output (14) and the relative height of the hysteresis being settable by variation of the resistance network ($R_H$).

2. Circuit arrangement according to Claim 1, having a logic circuit (21 to 24) for converting a Schmitt trigger output signal into an antivalent logic output signal, characterized in that the resistance network ($R_H$) can be switched over as a function of the logic circuit (21 to 24).

FIG 1

FIG 2

# FIG 3

# FIG 4

# FIG 5

EP 0 207 372 B1

FIG 6

FIG 7

FIG 8

EP 0 207 372 B1